# FASCICULE DE BREVET EUROPEEN

(11) **EP 1 151 480 B1**
(45) Date de publication et mention de la délivrance du brevet: **04.06.2014**
(21) Numéro de dépôt: 00985350.8
(22) Date de dépôt: 29.11.2000
(51) Int. Cl.: H01L 31/032, H01L 31/0336, H01L 31/0224, H01L 31/0216

(54) **CELLULE SOLAIRE A COUCHE MINCE**
DÜNNSCHICHT-SONNENZELLE
THIN-FILM SOLAR CELL

(30) Priorité: 07.12.1999 DE 19958878
(43) Date de publication de la demande: 07.11.2001
(73) Titulaire: SAINT-GOBAIN GLASS FRANCE, 92400 Courbevoie (FR)
(72) Inventeur: HÄUSSLER, Wulf, 52428 Jülich (DE); JANKE, Nikolas, 52134 Herzogenrath (DE); SCHÜTT, Jürgen, 52070 Aachen (DE)
(74) Mandataire: Renous Chan, Véronique
(86) Numéro de dépôt international: PCT/FR2000/003327
(87) Numéro de publication internationale: WO 2001/043204

(56) Documents cités:
- EP-A- 0 252 489
- EP-A- 0 372 929
- US-A- 5 078 804
- HERMANN A M ET AL: "Low-cost deposition of CuInSe2 (CIS) films for CdS/CIS solar cells" SOLAR ENERGY MATERIALS AND SOLAR CELLS,NL,ELSEVIER SCIENCE PUBLISHERS, AMSTERDAM, vol. 52, no. 3-4, 30 avril 1998 (1998-04-30), pages 355-360, XP004129744 ISSN: 0927-0248
- KUSHIYA K ET AL: "APPLICATION OF STACKED ZNO FILMS AS A WINDOW LAYER TO CU(INGA)SE2-BASED THIN-FILM MODULES" JAPANESE JOURNAL OF APPLIED PHYSICS,PUBLICATION OFFICE JAPANESE JOURNAL OF APPLIED PHYSICS. TOKYO,JP, vol. 38, no. 7A, juillet 1999 (1999-07), pages 3997-4001, XP000877719 ISSN: 0021-4922
- DEVANEY W E ET AL: "4-CM2 CUINGASE2 BASED SOLAR CELLS" RECORD OF THE PHOTOVOLTAIC SPECIALISTS CONFERENCE,US,NEW YORK, IEEE, vol. CONF. 21, 21 mai 1990 (1990-05-21), pages 535-540, XP000480324
- KUSHIYA K ET AL: "Development of Cu(InGa)Se2 thin-film slar cells with Zn-compound buffer" COMMISSION OF THE EUROPEAN COMMUNITIES. E.C. PHOTOVOLTAIC SOLAR ENERGY CONFERENCE. PROCEEDINGS OF THE INTERNATIONAL CONFERENCE, 23 octobre 1995 (1995-10-23), XP002092401

## Description

L'invention se rapporte à des cellules solaires à couche mince présentant les caractéristiques du préambule de la revendication indépendante 1.

Ces caractéristiques sont décrites dans la demande de brevet EP 0 372 929.

Il est connu que les cellules solaires photovoltaïques bâties sur un support comprennent une électrode frontale ou de fenêtre, une couche d'absorbeur et une électrode arrière.

D'une façon générale et dans ce qui suit, on appelle électrode de fenêtre l'électrode à travers le plan de laquelle la lumière à convertir en tension, respectivement en puissance, électrique pénètre dans la couche d'absorbeur.

L'électrode de fenêtre doit donc être aussi transparent que possible, respectivement présente une transmission élevée de la lumière, afin de ne pas réduire inutilement le rendement de la cellule solaire. Au contraire, l'électrode arrière prévue sur l'autre face de la couche d'absorbeur peut être relativement épaisse et opaque. Elle doit se caractériser essentiellement par une résistance électrique de surface aussi faible que possible et une bonne adhérence à la couche d'absorbeur ainsi que le cas échéant au substrat. Les électrodes arrière sont la plupart du temps fabriquées en molybdène métallique, qui remplit les conditions précitées.

Dans le type le plus répandu de cellules solaires à couche mince, l'électrode arrière est disposée entre un support, le substrat, et la couche d'absorbeur; l'électrode de fenêtre transparente se trouve sur la face de la cellule située à l'opposé du substrat. De même, le substrat ne doit dès lors pas nécessairement être transparent. Il peut être constitué de verre, de céramique, de films de polymère ou aussi de tôles métalliques.

Dans les cellules solaires à superstrate, l'électrode de fenêtre est disposée entre le support ici nécessairement aussi hautement transparent et le cas échéant antireflet peu réfléchissant et la couche d'absorbeur, de telle façon que la lumière parvienne à la couche d'absorbeur à travers le support et l'électrode de fenêtre. Ici, l'électrode arrière située à l'opposé du support ne doit pas être transparente.

La couche d'absorbeur est le plus souvent constituée d'une couche de chalcopyrite avec des additions de cuivre, indium et sélénium (dites couches d'absorbeur CIS), avec quelquefois aussi du soufre au lieu du sélénium. Occasionnellement, la couche d'absorbeur est aussi additionnée de gallium (couches d'absorbeur CIGS). La couche d'absorbeur présente en règle générale la conduction p. Pour fabriquer une transition pn, on applique sur la couche d'absorbeur à conduction p une couche tampon en une matière à conduction n d'une épaisseur de moins de 100 nm. Il est connu du brevet (US-4.611.091), d'utiliser du sulfure de cadmium (CdS) comme matière pour la couche tampon avec une électrode de fenêtre conductrice en ZnO placée pardessus.

Si l'on utilise comme matière pour l'électrode de fenêtre de l'oxyde de zinc (ZnO) ou un autre oxyde transparent, cette matière en soi diélectrique doit être déposée comme semi-conducteur dopé. La conductivité est obtenue par dopage, entre autres avec de l'aluminium ou du bore. A l'échelle industrielle, ces électrodes de fenêtre sont le plus souvent déposées par pulvérisation (pulvérisation cathodique sous champ magnétique) en surface sur la couche d'absorbeur. On a cependant alors besoin de couches d'une épaisseur de 400 nm et plus, pour limiter la résistance superficielle à un niveau utilisable. De ce fait, la transmission de la lumière est toutefois réduite par rapport à des couches plus minces. Un autre inconvénient de ce procédé est que les paramètres de la pulvérisation, en particulier la pression partielle d'oxygène dans l'atmosphère réactive de la chambre de pulvérisation, ne peuvent être réglés de façon variable que dans un domaine très étroit pour obtenir des résultats optimaux. Enfin, le dépôt de couches de ZnO relativement épaisses est également long et coûteux à cause d'une vitesse de revêtement relativement faible du zinc métallique dans une atmosphère réactive. En variante, on peut utiliser des cibles céramiques, qui se composent déjà de l'oxyde de zinc conducteur désiré. Il n'y a cependant aucun avantage en matière de vitesse de dépôt.

On peut certes produire une électrode de fenêtre en ZnO avec des résultats également encore utilisables au point de vue optique, par le dépôt chimique en phase vapeur (CVD / Chemical Vapor Deposition), on doit cependant admettre des épaisseurs de couche encore plus grandes atteignant jusqu'à 1500 nm pour obtenir par ce procédé une conductivité satisfaisante, parce que la densité matérielle des couches ainsi produites est inférieure à celle des couches déposées par pulvérisation.

On a également constaté qu'une couche relativement mince (par exemple 100 nm) en ZnO diélectrique entre la couche d'absorbeur et l'électrode de fenêtre en ZnO rendu conducteur par dopage augmentait le rendement de la cellule solaire, et qu'elle influençait aussi de façon positive la stabilité du procédé.

Un avantage de cette configuration est cependant que les cellules solaires connues avec des couches d'absorbeur CIS ont un potentiel de tension de repos, qui repose sur une différence de charge entre la couche d'absorbeur à conduction p et l'électrode de ZnO rendu conducteur par dopage (à conduction n).

L'invention a pour objet de proposer des cellules solaires à couche mince équipées de telles électrodes de fenêtre.

Conformément à l'invention, cet objectif est atteint par les caractéristiques de la revendication 1 en ce qui concerne les cellules solaires. Les caractéristiques des revendication secondaires respectivement dépendantes de la revendication indépendante 1 divulguent des variantes avantageuses de cet objet.

Ainsi, l'électrode de fenêtre peut être fabriquée avec une couche mince à base métallique, qui est traitée antireflets par au moins une couche d'oxyde ou de nitrure hautement réfringente au moins sur le côté d'incidence de la lumière et avec une couche de blocage selon la revendication 1.

Avec l'utilisation d'une couche métallique, respectivement d'une couche à base métallique, la conductivité de l'électrode de fenêtre est en général accrue. Avec le traitement antireflets au moins, sur le côté d'entrée de la lumière de la couche métallique (c'est-à-dire de sa surface opposée à la couche d'absorbeur), on assure que la lumière utilisable travers aussi effectivement l'électrode et n'est pas réfléchie pour la plus grande partie ou complètement à la surface de la couche métallique.

En principe, il est peu important que la couche antireflets soit elle-même électriquement conductrice ou non. Elle peut être déposée en une couche unique ou en une succession de couches, avec les seules limitations qu'elle doit d'une part être suffisamment transparence et d'autre part qu'elle adhère bien sur la couche métallique et qu'elle soit chimiquement compatible avec celle-ci.

Selon un mode de réalisation de l'invention, au moins une des couches diélectriques se compose d'oxyde de zinc.

Conformément à l'invention, la couche métallique se compose d'argent ou d'alliage d'argent et la couche antireflet est une couche d'oxyde ou de nitrure hautement réfringente

Dans une variante, une couche ou une succession de couches hautement réfringentes est également disposée entre la couche d'absorbeur et la couche métallique de l'électrode de fenêtre. Pour celle-ci également, il est en principe peu important qu'elle soit électriquement conductrice ou non, sachant qu'elle ne doit en aucun cas limiter sensiblement le flux de courant entre la couche d'absorbeur et l'électrode de fenêtre par sa résistance ohmique.

Sans sortir du cadre de l'invention, l'électrode de fenêtre peut comprendre successivement une première couche hautement réfringente, une première couche métallique, une deuxième couche hautement réfringente, une deuxième couche métallique et ladite couche antireflet.

Les couches hautement réfringentes, éventuellement diélectriques, peuvent être déposées de façon connue sous forme d'oxydes (ZnO, SnO₂, BiOₓ, TiO₂, Al₂O₃) ou de nitrures (AlN, Si₃N₄).

La cellule solaire selon l'invention comprend au moins une couche d'argent et une couche d'oxyde ou de nitrure hautement réfringente.

Selon l'invention, la couche d'argent, de l'électrode due fenêtre, a une épaisseur de moins de 20 nm et l'épaisseur totale de l'électrode de fenêtre est inférieure à 120 nm.

Pour protéger la mince couche conductrice déjà terminée contre l'oxydation pendant le dépôt d'une couche hautement réfringente, respectivement diélectrique, on peut éventuellement prévoir une couche de blocage à base par exemple de NiCr, Ti, Al ou Pb entre la couche à base métallique et la couche hautement réfringente, respectivement diélectrique, à déposer après celle-ci.

En principe, des successions de couches comprenant deux couches diélectriques avec une couche métallique intermédiaire (couche de fonction) sont connues d'une façon générale comme couches d'isolation thermique pour diminuer l'émissivité des vitrages de bâtiments ou d'automobiles. Les couches diélectriques y jouent le rôle de traitement antireflets de la couche métallique intermédiaire en raison de la différence d'indice de réfraction. Sans les couches diélectriques, la couche à base métallique réfléchirait trop fortement aussi la lumière visible, ce qui n'est en aucun cas souhaitable pour les vitrages d'automobiles.

Il est également connu qu'il existe une relation entre la conductivité électrique et l'effet d'isolation thermique de la couche de fonction, telle que sa réflexion de l'infrarouge est également élevée lorsque la conductivité est grande.

L'utilisation de telles successions de couches déjà largement employées et fabriquées en grandes dimensions comme électrodes de fenêtre offre d'une part l'avantage d'une fabrication nettement plus économique par comparaison avec les électrodes de fenêtre en ZnO conventionnelles, et d'autre part les épaisseurs totales de ces couches peuvent être notablement réduites en raison de la résistance de surface nettement moindre, par exemple d'une couche d'argent métallique, par rapport aux 400 nm de ZnO nécessaires jusqu'à présent.

L'élément de fenêtre selon l'invention peut donc comprendre une succession d'une première couche hautement réfringente, d'une première couche métallique et d'une deuxième couche hautement réfringente.

Ainsi, la résistance de surface nécessaire de R_{□} < 10 Ω_{□} peut être obtenue avec une couche d'argent de moins de 20 nm d'épaisseur, qui se trouve entre deux couches diélectriques d'environ 30 à 50 nm d'épaisseur. On peut donc ainsi réaliser une électrode de fenêtre de moins de 120 nm d'épaisseur.

Sans sortir du cadre de l'invention, l'élément de fenêtre peut aussi comprendre la succession qui vient d'être évoquée à laquelle s'ajoute une deuxième coche métallique et la couche antireflet. Dans cet empilement de cinq couches, la couche métallique peut se composer d'argent ou d'un alliage d'argent.

L'électrode de fenêtre conforme à l'invention peut être utilisée non seulement avec des cellules solaires à couche mince CIS, mais aussi pour des cellules solaires produites par d'autres technologies à couche mince en modèles à substrat ou à superstrat. Des cellules solaires avec du silicium amorphe ou du tellurure de cadmium comme couche d'absorbeur peuvent également être équipées de l'électrode de fenêtre discutée ici. On peut également imaginer de remplacer les deux couches d'électrode d'une cellule scolaire à couche mince par l'électrode transparente conforme à l'invention.

On peut aussi réaliser une combinaison de l'électrode contenant une couche métallique avec une mince couche d'oxyde conductrice, logée entre l'absorbeur et la couche métallique.

Pour la réalisation d'un exemple, on a déposé sur une cellule solaire à couche mince CIS de structure verre/Mo/CIS/CdS une électrode de fenêtre ayant la structure suivante:

| | |
|---|---|
| diélectrique 1 | ZnO env. 50 nm |
| blocage | Ti env. 3 nm |
| métal | Ag env. 15 nm |
| diélectrique 2 | ZnO env. 55 nm |
| | Si₃N₄ env. 30 nm, |

dans laquelle la couche de nitrure de silicium sert essentiellement de protection mécanique contre les dommages (griffues). Un effet supplémentaire peut être la diminution de la diffusion de l'humidité dans la couche d'absorbeur, qui abaisse la stabilité de stockage des cellules solaires non blindées, respectivement la stabilité climatique des modules solaires stratifiés.

Pour une couche de cette nature déposée sur du verre, on a déterminé une résistance de surface de R_{□} = 8,5 Ω_{□}. Sur une cellule solaire munie de cette couche, on a mesuré un taux de réflexion de 1,2 % dans le domaine du spectre visible. Par rapport aux électrodes de fenêtre conventionnelles, qui ont un taux de réflexion d'environ 8 %, cette structure de couche a donc un effet de réduction de la réflexion, elle apporte donc une transmission améliorée de la lumière dans la couche d'absorbeur.

L'échantillon a été divisé en quatre cellules solaires, sur chacune desquelles un contact métallique a été déposé par vaporisation. En guise de référence, on a déposé sur une cellule solaire ayant la même structure du ZnO:Al rendu conducteur par dopage à l'aluminium comme électrode de fenêtre.

Sur ces cellules solaires, on a mesuré les grandeurs caractéristiques suivantes:

| | Tension à vide | Courant de court-circuit | Taux de remplissage | Rendement |
|---|---|---|---|---|
| | U_{oc} [mV] | I_{sc} [mA/cm²] | FF [%] | η [%] |
| Cellule 1 | 522 | 24,1 | 66,5 | 8,4 |
| Cellule 2 | 535 | 23,9 | 66,6 | 8,5 |
| Cellule 3 | 517 | 24,8 | 66,3 | 8,5 |
| Cellule 4 | 509 | 24,8 | 64,9 | 8,2 |
| Référence | 610 | 31 | 77 | 14,6 |

Certes, les valeurs des cellules 1 à 4 sont inférieures aux valeurs de comparaison mesurées avec la cellule de référence, on a cependant dans une première étape fait la preuve de l'applicabilité de principe de l'électrode de fenêtre en sandwich. On escompte aussi pouvoir obtenir des valeurs encore meilleures par une optimisation adéquate du dépôt et des épaisseurs de couche.

Le rendement comparativement plus bas des cellules solaires avec l'électrode de fenêtre conforme à l'invention s'explique par le fait que le domaine de longueurs d'onde, dans lequel l'électrode de fenêtre est transparente (environ 300 nm à 900 nm) est plus petit que le domaine de grande sensibilité spectrale de la couche d'absorbeur (environ 300 nm à 1300 nm). Dans ce cas spécifique, la quantité de lumière incidente utilisable dans le domaine de longueurs d'onde entre environ 900 nm et 1300 nm est ainsi réfléchie par l'électrode de fenêtre.

On peut s'attendre à des résultats comparables à ceux de l'échantillon de référence lorsque le domaine de haute transmission de l'électrode de fenêtre aura été davantage adapté à la sensibilité spectrale de l'absorbeur, c'est-à-dire après la possibilité que l'électrode de fenêtre soit également transparente pour des longueurs d'onde supérieures à 900 nm jusqu'environ 1300 nm. Des possibilités d'abaisser le seuil de réflexion supérieur en influençant la conductivité de la couche métallique sont bien connues de l'homme de métier. La conductivité de la couche métallique chute cependant lorsque l'on augmente sa transparence pour de plus grandes longueurs d'onde.

## Revendications

1. Cellule solaire à couche mince comprenant une couche d'absorbeur en particulier de type CIS, et au moins une électrode de fenêtre transparente disposée sur le côté d'incidence de la lumière, l'électrode de fenêtre est formée d'une succession de couches comprenant au moins une première couche diélectrique d'oxyde ou de nitrure hautement réfringente, une couche métallique et une autre couche diélectrique antireflet déposée sur le côté d'incidence de la lumière situé à l'opposé de la couche d'absorbeur et qui est une couche d'oxyde ou de nitrure hautement réfringente,
la couche métallique se compose d'argent ou d'alliage d'argent, a une épaisseur de moins de 20 nm et l'épaisseur totale de l'électrode de fenêtre est inférieure à 120 nm,
**caractérisée en ce que**, entre la couche métallique et ladite première couche d'oxyde ou de nitrure hautement réfringente, est disposée une couche de blocage en titane.

2. Cellule solaire selon la revendication 1, **caractérisée en ce que** l'électrode de fenêtre comprend successivement ladite première couche hautement réfringente, ladite première couche métallique, une deuxième couche hautement réfringente, une deuxième couche métallique et ladite couche antireflet.

3. Cellule solaire à couche mince la revendication 1 ou 2, **caractérisée en ce que**, au moins une des couches hautement réfringentes se compose de l'un des oxydes ZnO, SnO₂, BiOₓ, TiO₂, Al₂O₃ et/ou de l'un des nitrures AlN, Si₃N₄.

## Patentansprüche

1. Dünnschichtsolarzelle, umfassend eine Absorberschicht insbesondere vom Typ CIS sowie wenigstens eine transparente Fensterelektrode, die auf der Lichteinfallseite angeordnet ist, die Fensterelektrode ist von einer Folge von Schichten gebildet, die wenigstens eine erste hochbrechende dielektrische Oxid- oder Nitridschicht, eine Metallschicht und eine weitere dielektrische Antireflexschicht, die auf der von der Absorberschicht abgewandten Lichteinfallseite aufgebracht ist und die eine hochbrechende Oxid- oder Nitridschicht ist, umfasst,
die Metallschicht besteht aus Silber oder aus Silberlegierung, weist eine Dicke von weniger als 20 nm auf, und die Gesamtdicke der Fensterelektrode beträgt weniger als 120 nm,
**dadurch gekennzeichnet, dass** zwischen der Metallschicht und der ersten hochbrechenden Oxid- oder Nitridschicht eine Sperrschicht aus Titan angeordnet ist.

2. Solarzelle nach Anspruch 1, **dadurch gekennzeichnet, dass** die Fensterelektrode nacheinander die erste hochbrechende Schicht, die erste Metallschicht, eine zweite hochbrechende Schicht, eine zweite Metallschicht und die Antireflexschicht umfasst.

3. Dünnschichtsolarzelle nach Anspruch 1 oder 2, **dadurch gekennzeichnet, dass** wenigstens eine der hochbrechenden Schichten aus einem der Oxide ZnO, SnO₂, BiOₓ, TiO₂, Al₂O₃ und/oder aus einem der Nitride AlN, Si₃N₄ besteht.

## Claims

1. Thin-film solar cell comprising an absorber layer particularly of the CIS type, and at least one transparent window electrode placed on that side on which the light is incident, the window electrode is formed from a succession of layers comprising at least a first highly refracting oxide or nitride dielectric layer, a metallic layer and another antireflection dielectric layer deposited on that side on which the light is incident lying on the opposite side from the absorber layer and which is a highly refracting oxide or nitride layer, the metallic layer is composed of silver or of a silver alloy, has a thickness of less than 20 nm and the total thickness of the window electrode is less than 120 nm, **characterized in that** a titanium blocking layer is placed between the metallic layer and said first highly refracting oxide or nitride layer.

2. Solar cell according to Claim 1, **characterized in that** the window electrode comprises, in succession, said first highly refracting layer, said first metallic layer, a second highly refracting layer, a second metallic layer and said antireflection layer.

3. Thin-film solar cell Claim 1 or 2, **characterized in that** at least one of the highly refracting layers is composed of one of the oxides ZnO, SnO₂, BiOₓ, TiO₂, Al₂O₃ and/or one of the nitrides AlN, Si₃N₄.
